Europäisches Patentamt

European Patent Office

Office européen des brevets

(19)

(11) EP 0 646 975 B1

(12) EUROPÄISCHE PATENTSCHRIFT

(45) Veröffentlichungstag und Bekanntmachung des Hinweises auf die Patenterteilung:
21.01.1998 Patentblatt 1998/04

(51) Int Cl.⁶: H01L 41/09

(21) Anmeldenummer: 94202722.8

(22) Anmeldetag: 22.09.1994

(54) **Torsionsaktuator und ein Verfahren zu dessen Herstellung**

Tortional actuator and method of making the same

Organe d'actionnement à torsion et procédé de sa fabrication

(84) Benannte Vertragsstaaten:
AT DE FR GB

(30) Priorität: 28.09.1993 DE 4332966

(43) Veröffentlichungstag der Anmeldung:
05.04.1995 Patentblatt 1995/14

(73) Patentinhaber:
• Philips Patentverwaltung GmbH
22335 Hamburg (DE)
Benannte Vertragsstaaten:
DE
• PHILIPS ELECTRONICS N.V.
5621 BA Eindhoven (NL)
Benannte Vertragsstaaten:
FR GB AT

(72) Erfinder:
• Dibbern, Uwe, Dr.c/o Philips Patentverwaltung GMBH
D-20097 Hamburg (DE)
• Pankert, Joseph, Dr.
Philips Patentverwaltung GMBH
D-20097 Hamburg (DE)

(74) Vertreter: Hartmann, Heinrich, Dipl.-Ing. et al
Philips Patentverwaltung GmbH,
Röntgenstrasse 24
22335 Hamburg (DE)

(56) Entgegenhaltungen:
EP-A- 0 516 175          WO-A-89/07258
US-A- 5 001 382

• PATENT ABSTRACTS OF JAPAN vol. 010 no. 251 (E-432) ,28.August 1986 & JP-A-61 079270 (OLYMPUS OPTICAL CO LTD) 22.April 1986

**Beschreibung**

Die Erfindung betrifft einen Torsionsaktuator mit den Merkmalen des Oberbegriffs des Patentanspruches 1 sowie ein Verfahren zu dessen Herstellung mit den Merkmalen des Oberbegriffs des Patentanspruches 11.

Torsionsaktuatoren sind bekannt. Es handelt sich dabei jeweils um einen piezoelektrischen Aktuator, dessen Ende unter dem Einfluß eines elektrischen Feldes um einen kleinen Winkel tordiert. Ein derartiger Torsionsaktuator kann quaderförmig ausgestaltet sein, mit einer fest eingespannten rechteckförmigen Rückfläche, deren Abmessungen so gewählt sind, daß der Torsionsaktuator plattenförmige Gestalt hat. Wird der Torsionsaktuator in Betrieb genommen, verdreht sich die der eingespannten Seite gegenüberliegende um deren Längsachse herum mit dem größten Verdreh- oder Torsionswinkel.

Prinzipiell kann ein Torsionsaktuator als eine Kombination von zwei piezoelektrischen Biegeaktuatoren betrachtet werden, die nebeneinanderliegend miteinander verbunden sind und Elektroden aufweisen. Die Verdrehung erfolgt dann, wenn sich der eine der Biegeaktuatoren nach oben und der andere unten verbiegt.

Dieser grundsätzliche Aufbau ist aus dem US-Patent 4,233,637 bekannt und weist eine einfache, quaderförmige ein- und zweischichtige bimorphe Anordnung auf, die sowohl als Torsionsaktuator als auch als Biegeaktuator verwendet werden kann. Dieser einfache bimorphe Torsionsaktuator hat den Nachteil, daß die elektrischen Steuerspannungen wegen der großen Schichtdicken sehr hoch sein müssen.

Ein weiterer Aktuator ist aus der PCT-Patentanmeldung mit der internationalen Veröffentlichungs-Nr. WO 89/02658 bekannt und aus piezoelektrischen Polymerfolien aufgebaut, die jedoch wegen ihrer elastischen und piezoelektrischen Eigenschaften nur bedingt für Aktuatoren geeignet sind, da die realisierbaren Kräfte bzw. Drehmomente recht klein sind. Die Polymerfolien haben auch eine Vorzugsrichtung in der Schichtebene, was zwar ausgenutzt wird, um mit einfachen durchgehenden Elektroden komplizierte Verformungen zu erreichen. Allerdings können jeweils nur ein Teil, einige oder jedenfalls wenige Lagen des gesamten Materials aktiv sein, so daß die realisierbaren Kräfte bei gegebenem Volumen verhältnismäßig klein sind.

Der Erfindung liegt die Aufgabe zugrunde, einen Torsionsaktuator zu schaffen, der einfach aufgebaut ist, bereits bei geringen Steuerspanungen einen großen Torsionswinkel aufweist, im Bereich von Werkzeugmaschinen und/oder zur Videokopfführung geeignet und durch ein einfaches Herstellungsverfahren kostengünstig herstellbar ist.

Diese Aufgabe wird erfindungsgemäß hinsichtlich des Torsionsaktuators selbst durch die kennzeichnenden Merkmale des Anspruches 1 und hinsichtlich des Verfahrens zu seiner Herstellung durch die kennzeichnenden Merkmale des Anspruches 11 gelöst.

Vorteilhafte Ausgestaltungen der Erfindung ergeben sich aus den Unteransprüchen.

Der erfindungsgemäße plattenförmige Torsionsaktuator ist grundsätzlich aus einem monolithischen Block aus piezoelektrischer Keramik hergestellt und mit mindestens innenliegenden Elektroden und äußeren Kopfkontakten versehen, die mit den Steuerspannungen beaufschlagt werden.

Dadurch, daß der erfindungsgemäße Torsionsaktuator in Vielschichttechnik aufgebaut ist, ergeben sich zum einen Vorteile, nämlich durch kleine Spannungen große Torsionswinkel zu erzeugen und zum anderen hinsichtlich der möglichen Verwendung des Torsionsaktuators im Bereich von Werkzeugmaschinen als Stellglied oder zur Videokopfführung (track following system). Denn gegenüber der einangs genannten Patentanmeldung WO-89/02658 ist der erfindungsgemäße Torsionsaktuator z.B. durchaus im Stande, verhältnismäßig hohe Kräfte bzw. Drehmomente zu erzeugen.

Gemäß einer besonderen Ausgestaltung der Erfindung können neben inneren Elektroden jeweils eine untere bzw. obere äußere Elektrode vorgesehen sein, die im Abstand zum äußeren Rand der jeweiligen piezoelektrischen Schicht angeordnet sind. Zur Kontaktierung dieser äußeren Elektroden ist dann vorteilhaft jeweils ein Abschnitt vorgesehen, der bis an den äußeren Rand der piezoelektrischen Schicht ragt und dort in Gruppen mit anderen Elektroden in bestimmter Weise kontaktiert werden kann. Die Kontaktierungen erfolgen erfindungsgemäß über Kopfkontakte, die seitlich am Torsionsaktuator angeordnet sind und eine derartige Kontaktierung ermöglichen, daß sich eine Verwindung des Torsionsaktuators um seine Längsachse herum ergibt. Die äußeren Elektroden können auch ganzflächig die Schichten abdecken. Bei einer derartigen vorteilhaften Ausführung sind die Anschlußflächen durch eine Ausnehmung gegenüber dem übrigen Rand elektrisch abzugrenzen.

Bei Betrachtung der Stirnfläche des an sich quaderförmigen Torsionsaktuators kann durch gedachte Mittellinien eine Aufteilung in vier Quadranten eines kartesischen Koordinatensystems erfolgen. Erfindungsgemäß ergibt sich eine Verwindung, wenn die Spannungen bzw. die Potentiale der jeweils ersten Elektroden in den Quadranten 1 und 4 gleichgroß und positiv und in den Quadranten 2 und 3 gleichgroß und negativ gegenüber einer Referenzspannung sind, die durch mindestens eine Elektrode in der gedachten horizontalen Mittellinie bereitgestellt wird. Die Polarisation der angrenzenden piezoelektrischen Schichten ist dabei orthogonal zur mittleren Elektrode und gleich ausgerichtet. Selbstverständlich können auch alle Vorzeichen vertauscht werden. Auch können die Potentiale der Elektroden anders gewählt werden, wenn die Polarisation der Schichten verändert wird. Bei dem anmeldungsgemäßen vielschichtigen Torsionsaktuator sind dann alternierend von dieser mittleren Elektrode nach oben und unten weisend Elektroden vorgesehen, die ebenfalls die Referenzspannung aufweisen, wobei die jeweils dazwischen angeordneten Elektroden die entsprechend den Quadranten erforderlichen Spannungen aufweisen.

Die Elektroden sind durch die Längsachse des Torsionsaktuators in zwei Teile elektrisch unterteilt. Dies kann für alle Elektroden so vorgesehen sein, jedoch können die Elektroden, die die Referenzspannung aufweisen auch durchgehend ausgeführt sein. Dies entspricht dann einer besonderen Ausgestaltung der Erfindung.

Wie bereits erwähnt, können gemäß einer besonderen Ausgestaltung der Erfindung auch die untere und obere äußere Fläche mit Elektroden versehen sein, die dann sowohl die jeweils darunterliegende piezoelektrische Keramikschicht aktivieren als auch eine elektrische Abschirmung bewirken, sofern sie die Referenzspannung aufweisen.

Überraschenderweise hat sich gezeigt, daß eine theoretische Berechnung mit durchgeführten Versuchen recht gut korrespondiert, so daß in äußerst vorteilhafter Weise eine geometrische Optimierung des an sich quaderförmigen Torsionsaktuators angegeben werden kann. So kann, ausgehend von einer vorgegebenen Ladungskonstante, die Aussage getroffen werden, daß mit abnehmender Dicke bzw. Höhe der mögliche Torsionswinkel zunimmt. Allerdings sind hier u.a. Stabilitätsgrenzen gegeben. Überraschenderweise hat sich gezeigt, daß das Verhältnis der größten Länge zur halben Breite des Torsionsaktuators vorteilhaft zwischen 1 und 3 liegen sollte. Ist aufgrund baulicher Gegebenheiten am Einsatzort dagegen die maximale Länge des Torsionsaktuators begrenzt, aber deren Breite noch frei wählbar, dann kann der Torsionswinkel maximiert werden, indem das Verhältnis Länge zur halben Breite etwa bei 0,9 gewählt wird.

Gemäß einer besonderen Ausgestaltung der Erfindung kann ferner der Torsionswinkel durch Abweichung von der rechteckigen Grundform des Torsionsaktuators verbessert werden. Hierzu wird eine trapezförmige Grundfläche gewählt, bei der die breitere Stirnseite die bewegliche darstellt und diese doppelt so breit wie die gegenüberliegende als Auflager dienende Seite ist. Der Torsionswinkel kann dadurch um etwa 33 % gegenüber dem Torsionsaktuator mit rechteckiger Grundfläche vergrößert werden.

Durch Wahl anderer Spannungen, wie $U_1 = U_2$ und $U_3 = U_4$ kann der Torsionsaktuator verbogen werden, wodurch die Lage seiner Längsachse beeinflußbar ist, was besonders bei der Videokopfführung vorteilhaft ist.

Um die erforderlichen Spannungen in den vier Quadranten zu erzeugen, sind mindestens hinsichtlich der inneren Elektroden insgesamt drei verschiedene Siebdruckmasken erforderlich.

Erfindungsgemäß wird ein Verfahren angegeben, daß es ermöglicht, mit wenigen Siebdruckmasken auszukommen und direkt beim Trennen von mehreren nebeneinander erzeugten Torsionsaktuatoren quasi automatisch die erforderlichen Kontakte bzw. Anschlußflächen in den nötigen Gruppierungen übereinanderliegend an den Seitenflächen des Torsionsaktuators zur Verfügung zu stellen, um dort die entsprechenden Kopfkontakte anzubringen. Gemäß einer ersten Maskenanordnung werden drei verschiedene Masken mit unterschiedlichem Layout verwandt. Nach jedem Druckvorgang ist ein Maskenwechsel erforderlich.

Gemäß einer weiteren Ausgestaltung dieses Verfahrens wird die jeweilige Maske beispielsweise dreifach in einer horizontalen Reihe wiederholt. Auch ist es denkbar, die Wiederholung in senkrechter Richtung vorzunehmen. Die Maskenstruktur selbst kann dabei z.B. durch Drehen oder Spiegeln leicht abgewandelt werden. Nach dem Herstellen mehrerer Torsionsaktuatoren kann dann beispielsweise durch Sägen die Trennung in einzelne Aktuatoren entlang vorgegebener Trennlinien erfolgen. Dabei werden die Anschlußflächen zu den äußeren Kopfkontakten auf den Trennflächen freigelegt.

Um die Anzahl der drei aufwendigen Wechsel der Masken bei dieser ersten Maskenanordnung zu vermindern, kann gemäß einer weiteren Ausgestaltung des erfindungsgemäßen Verfahrens eine Anordnung mit nur zwei Masken zum Einsatz kommen, die in je zwei unterschiedlichen Positionen benutzt werden. Die beiden Positionen werden durch Verschiebung der Masken nach jedem Druck um eine halbe Breite des Aktuators erreicht. Auch hierbei werden die mehreren gleichzeitig hergestellten Aktuatoren anschließend entlang bestimmter Trennlinien voneinander getrennt, wobei jedoch letztlich nur ein Maskenwechsel erfolgen muß. Nachteilig bei dieser zweiten Maskenanordnung ist die Tatsache, daß links oder rechts von einer Reihe von Masken durch die Verschiebung eine halbe Maskenfläche verlorengeht.

Die Entstehung der Kontaktierungen zu den Kopfkontakten ist wieder durch entsprechend angeordnete Anschlußbereiche gewährleistet. Allerdings ist der Referenzanschlußbereich zweimal vorhanden und erfordert somit zwei Kopfkontakte, die anschließend zu verbinden sind.

Ausführungsbeispiele der vorliegenden Erfindung werden nachfolgend unter Bezugnahme auf eine Zeichnung näher erläutert. Darin zeigt:

Fig. 1 eine perspektivische Ansicht eines erfindungsgemäßen Torsionsaktuators,

Fig. 2 einen Ausschnitt von zwei mittleren Schichten des Torsionsaktuators nach Fig. 1 in einer durch die Achsen $x_2$ und $x_3$ aufgespannten Schnittebene,

Fig. 3 die elektrische Kontaktierung eines erfindungsgemäßen Torsionsaktuators anhand einer schematisierten Schnittdarstellung entsprechend Fig. 2,

Fig. 4 einen erfindungsgemäßen Torsionsaktuator mit mehreren inneren Elektroden in perspektivischer teilweise aufgebrochener und geschnittener Darstellung,

Fig. 5 eine erste Maskenanordnung zur Herstellung eines erfindungsgemäßen Torsionsaktuators,

Fig. 6 eine zweite Maskenanordnung zur Herstellung eines erfindungsgemäßen Torsionsaktuators, und

Fig. 7 eine Draufsicht auf einen Torsionsaktuator gemäß einer Weiterbildung.

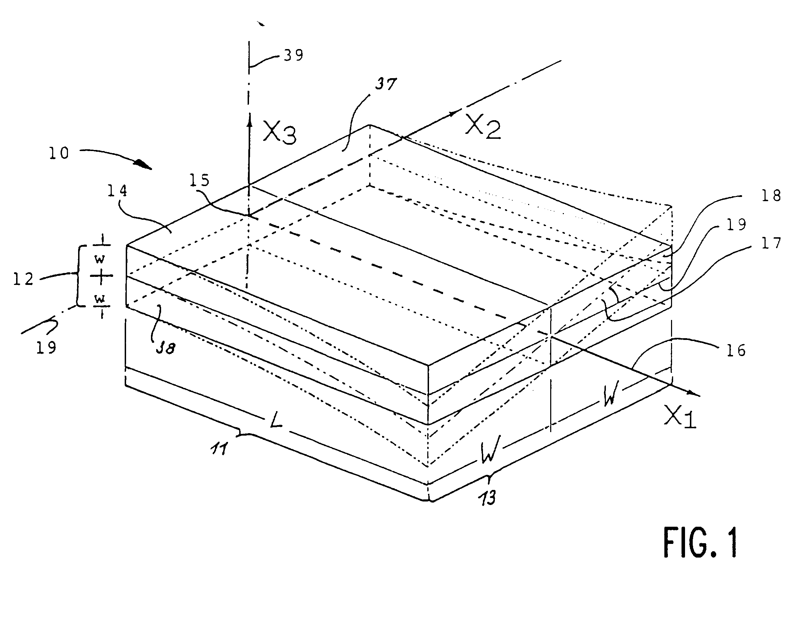

Fig. 1 zeigt einen erfindungsgemäßen Torsionsaktuator 10 mit einer Länge 11, formelmäßig L, einer Höhe bzwc Dicke 12, formelmäßig 2w und einer Breite 13, formelmäßig 2W. Der Mittelpunkt 15 der in der Fig. 1 hinteren Seitenfläche 14 des Torsionsaktuators 10 bildet gleichzeitig den Ursprung eines kartesischen Koordinatensystems mit den Achsen $x_1$, $x_2$ und $x_3$, wobei $x_1$ und $x_2$ Achsen in der Horizontalen sind und $x_3$ eine Achse in der Vertikalen ist. Die Achse $x_1$ bildet gleichzeitig die mittlere Längs- bzw. Torsionsachse 16 des Torsionsaktuators 10. Der größte Torsionswinkel in einer Ausschlagrichtung ist auf der der Seitenfläche 14 gegenüberliegenden Seite 18 mit dem Bezugszeichen 17 gekennzeichnet und wird formelmäßig mit $Tw_r$ bezeichnet. Er kann bis zu einigen Grad betragen. Der in Fig. 1 dargestellte Torsionswinkel 17 wird aufgespannt zwischen den horizontalen Mittellinien 19 des mit durchgehenden Linien dargestellten Torsionsaktuator 10 und des mit Strichpunktlinien dargestellten verdrehten Torsionsaktuators 10. Der dargestellte Torsionswinkel 17 entspricht der Verdrehung des Torsionsaktuators 10 in einer Richtung infolge einer bestimmten Polarität seiner Elektroden und piezoelektrischen Schichten. Bei anderer Polarität ergibt sich eine Verdrehung in entgegengesetzter Richtung um den gleichen Winkel 17. Für den Fall der Verwendung des Torsionsaktuators 10 beispielsweise zur Videokopfführung oder im Rahmen einer Werkzeugmaschine ist die Seitenfläche 14 in der in Fig. 1 gezeigten Position fest zu positionieren. Nebenbei sei erwähnt, daß auch die umgekehrte Wirkungsweise, also nicht als Stellglied sondern beispielsweise als Drehmomentsensor möglich ist.

Die Abmessungen des quaderförmigen Torsionsaktuators 10 sind derart, daß er eine plattenförmige Gestalt hat. Seine Seitenfläche 14 ist fest eingespannt. Ohne irgendwelche an den Elektroden anliegenden Spannungen ist er unverdreht. Werden jedoch geeignete Spannungen bei bestimmter Polarisation der Schichten 20 angelegt, verdreht er sich um die Achse $x_1$ herum, wobei der größte Verdreh- oder Torsionswinkel 17 an der Spitze, also bei $x_1 = L$ gefunden wird.

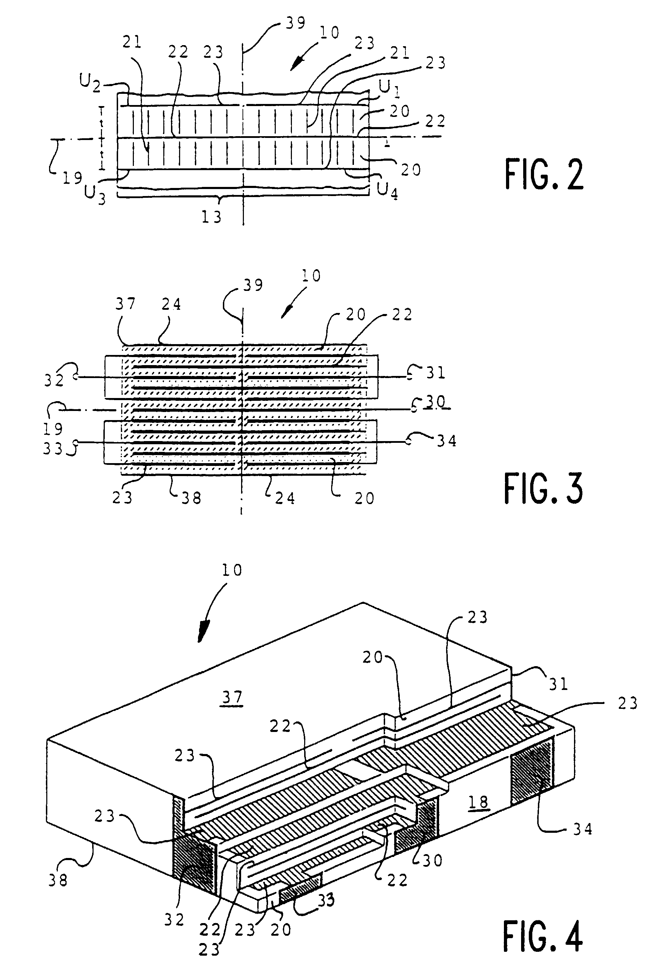

Fig. 2 zeigt einen Schnitt in einer durch die Achsen $x_2$ und $x_3$ aufgespannten Ebene durch den Torsionsaktuator 10 gemäß Fig. 1. Der Einfachheit halber wurde nur ein Bimorph dargestellt: also die Beschichtung von zwei in bestimmter Weise polarisierten piezokeramischen Schichten 20 mit der der Dicke t. Der Übergang von diesem Bimorphbieger zu einem Vielschichtbieger wird weiter unten erläutert. Die Pfeile 21 in den piezokeramischen Schichten 20 zeigen irgendeine mögliche Richtung der Polarisation an. Grundsätzlich kann für die Polarisation in einem oder mehreren der durch die Mittellinien 19, 39 gebildeten Quadranten auch eine entgegengesetzte Polarisationsrichtung gewählt werden. Das Verhalten des Torsionsaktuators 10 ändert sich nicht, wenn mit der Polarisation die angelegte Spannung ebenfalls ihr Vorzeichen wechselt. Die mittlere Elektrode 22, die halbseitig getrennt oder durchgehend ausgeführt sein kann, stellt die Referenzelektrode dar. Die weiteren Elektroden 23 sind dagegen halbseitig geteilt, überragen galvanisch also nicht die Achse $x_1$. Die elektrischen Spannungen in den vier Quadranten bzw. Potentiale an den Elektroden 23 werden mit $U_1$, $U_2$, $U_3$ und $U_4$ bezeichnet und bestimmen die Verformung des Torsionsaktuators.

Eine erfindungsgemäße Torsion erfolgt, wenn bei bestimmten Polarisationen gemäß Fig. 2 z.B. $U_1 = -U_2 = -U_3 = U_4$ gewählt wird. Da die Verformungen linear von den Spannungen abhängen, kann eine Kombination der Verformungen Biegen und Verdrehen durch eine unproblematische Addition der zugehörigen Spannungen erzielt werden. Eine reine Verbiegung ergibt sich z. B. bei $U_1 = U_2 = U_3 = U_4$.

Wie eingangs erwähnt, haben bekannte bimorphe Torsionsaktuatoren den Nachteil, daß deren Steuerspannungen wegen der großen Schichtdicke sehr hoch sind. Sie liegen im Bereich von einigen Kilovolt. Dieser Nachteil läßt sich umgehen, wenn Aktuatoren in Vielschichttechnik aufgebaut werden. Ein Vielschichtaktuator, entsprechend dem erfindungsgemäßen Torsionsaktuator 10, ist grundsätzlich ein monolithischer Block aus piezoelektrischer Keramik mit innenliegenden Elektroden 22 und 23, deren gegenseitige Kontaktierung, wie auch die zum Anschluß von Steuerspannungen über Kopfkontakte 30 bis 34 (siehe Fig. 4) gewährleistet wird.

Fig. 3 zeigt die prinzipielle elektrische Verschaltung der Kopfkontakte 30 bis 34 anhand eines schematischen Querschnittes in der durch die Achsen $x_2$ und $x_3$ aufgespannten Ebene eines Torsionsaktuators 10 gemäß Fig. 1. Die piezoelektrischen Keramikschichten 20 sind schraffiert und die inneren Elektroden 22 und 23 dick hervorgehoben. Zusätzlich zu den inneren Elektroden 22 und 23 sind äußere Elektroden 24 vorhanden und mit der Kopfelektrode 30 verbunden. Ebenfalls mit der Kopfelektrode 30 sind die inneren Elektroden 22 verbunden. Die inneren Elektroden 22 und 23 sind in der linken Figurenhälfte der Fig. 3 von unten nach oben nacheinander wie folgt kontaktiert: Elektrode 23 mit Kopfkontakt 33, Elektrode 22 mit Kopfkontakt 30, Elektrode 23 mit Kopfkontakt 33, Elektrode 22 mit Kopfkontakt 30, Elektrode 23 mit Kopfkontakt 33, Elektrode 22 mit Kopfkontakt 30, Elektrode 23 mit Kopfkontakt 32, Elektrode 22 mit Kopfkontakt 30, Elektrode 23 mit Kopfkontakt 32, Elektrode 22 mit Kopfkontakt 30, Elektrode 23 mit Kopfkontakt 32. Die rechte Hälfte folgt dem gleichen Prinzip, wobei der Kopfkontakt 33 durch Kopfkontakt 34 und der Kopfkontakt 32 durch Kopfkontakt 31 zu ersetzen ist.

Fig. 4 zeigt den inneren Aufbau des erfindungsgemäßen Torsionsaktuators 10, der dazu perspektivisch und teilweise aufgeschnitten dargestellt ist. Deutlich zu erkennen sind die fünf Kopfkontakte 30 bis 34, von denen Kopfkontakt 30 der Referenzelektrode 22 in Fig. 1 und der Kopfkontakt 30 in Fig. 3 entspricht. Der Kopfkontakt 31 repräsentiert die Spannung $U_1$, der Kopfkontakt 32 die Spannung $U_2$, der Kopfkontakt 33 die Spannung $U_3$ und der Kopfkontakt 34 die Spannung $U_4$. Der in Fig. 4 gezeigte Aufbau des Torsionsaktuators 10 zeigt sieben innere Elektroden 22 bzw. 23. Es sind selbstverständlich auch mehr oder weniger Elektroden möglich. Die mit dem Kopfkontakt 30 verbundenen Elektroden sind in der Mitte nicht unterteilt, was für deren Funktion jedoch nicht zwingend ist. Die geteilten inneren Elektroden 23 sind in der oberen Hälfte mit dem Kopfkontakt 31 bzw. 32 und in der unteren Hälfte mit den Kopfkontakten 34 bzw. 33 verbunden. In Fig. 4 ist ferner angenommen, daß die Elektroden 22 und 23 mit Ausnahme ihres Anschlusses an den entsprechenden Kopfkontakten nicht nach außen durchgehen.

Die den in Fig. 4 dargestellten Torsionsaktuator 10 oben und unten begrenzenden Flächen 37, 38 weisen keine zusätzlichen Elektroden 24 auf, wie sie in Fig. 3 dargestellt sind. Die ganz oben bzw. ganz unten liegende Keramikschicht 20 trägt somit nicht zur Torsionswirkung bei. Zur Verstärkung können jedoch ohne weiteres oben und unten zusätzliche Elektroden 24 vorgesehen sein, die dann mit dem Kopfkontakt 30 zu verbinden sind. Wenn der Kopfkontakt 30 dabei auf Massepotential liegt, bewirken diese äußeren Elektroden 24 eine zusätzliche Abschirmung.

Für einen Torsionsaktuator 10 mit der Geometrie gemäß Fig. 1 bzw. Fig. 4 hat sich die folgende Formel zur Berechnung des Torsionswinkels 17 überraschenderweise als sehr gut mit der Realität übereinstimmend ergeben, wie Versuche ergeben haben. Der Torsionswinkel 17, also $Tw_r$ ergibt sich danach wie folgt:

$$Tw_r = \frac{9}{8} \cdot \frac{(1+\sigma) \cdot d_{31} \cdot W/w \cdot L^2}{[1 + (1+\sigma) \cdot K^2/8] \cdot W^2 + 2 \cdot (1-\sigma) \cdot L^2} \cdot \frac{U}{w}$$

Darin ist U/w die elektrische Feldstärke, σ das Poissonverhältnis, $d_{31}$ die Ladungskonstante des Materials und $K^2 = k_p^2/(1-k_p^2)$ wobei $k_p$ der planare Kopplungsfaktor ist. Mittels dieses Ausdrucks kann man eine geometrische Optimierung vornehmen. Bei gegebener Ladungskonstante $d_{31}$ wird der Winkel 17 mit abnehmender Dicke zunehmen; hier sind jedoch technologische Grenzen, aber auch die mechanische Stabilität zu beachten. Eine große Länge L/W > 1 ist vorteilhaft, aber oberhalb L/W > 3 tritt eine Sättigung des Torsionswinkel auf. Ist dagegen L begrenzt, aber die Breite W noch frei, kann der Winkel $Tw_r$ maximiert werden, indem L/W ≈ 0.9 gesetzt wird.

Fig. 7 zeigt eine Draufsicht auf den Torsionsaktuator 10 entsprechend Fig. 1, wobei die Seite 14 eine maximale Breite 13 von 2W aufweist und die Seite 18 eine maximale Breite 13' von 2W'. W' ist dabei größer als W gewählt, so daß die Grundfläche dieses weitergebildeten Torsionsaktuators 10 eine trapezförmige Gestalt annimmt. Überraschenderweise hat sich nämlich gezeigt, daß eine weitere Verbesserung gegenüber der üblichen rechteckigen Grundfläche des plattenförmigen Torsionsaktuators 10 durch die Wahl einer trapezförmigen Grundfläche verbessert werden kann. Rechnung und Versuche zeigen hier, daß der Torsionswinkel 17 um etwa 33 % gesteigert werden kann, wenn W' doppelt so groß wie W ist.

Nachfolgend wird ein besonderer Verfahrensschritt zur Vereinfachung der Herstellung des Torsionsaktuators 10 beschrieben.

Wie aus Fig. 4 ersichtlich, weisen die inneren Elektroden 22 bzw. 23 drei verschiedene flächige Ausgestaltungen auf, und erfordern somit drei verschiedene Siebdruckmasken, um Kontakte zu den Kopfkontakten 30 bis 34 herzustellen.

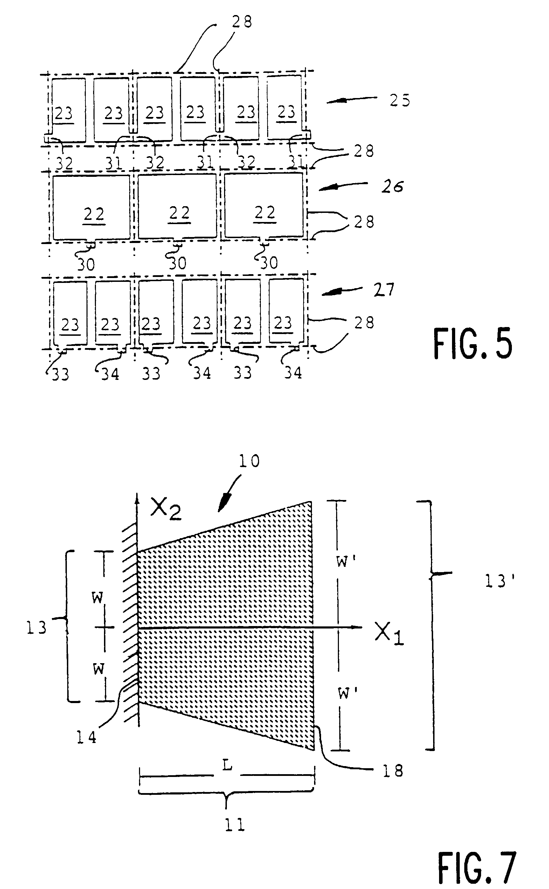

Fig. 5 zeigt eine erste Maskenanordnung mit drei verschiedenen Siebdruckmasken 25, 26 und 27. Eine für den Torsionsaktuator 10 nach Fig. 4 geeignete Reihenfolge der Masken von unten nach oben für die inneren Elektroden 22 und 23 wäre: Maske 27, Maske 26, Maske 27, Maske 26, Maske 25, Maske 26 und zuletzt Maske 25. Werden äußere Elektroden 24 vorgesehen, dann müßten diese durch die Maske 26 erzeugt werden.

Eine andere geeignete Reihenfolge der Masken bei der Fertigung wäre Maske 25, 26, 25, 26, 25, ..., Maske 25, Maske 26, Maske 27, Maske 26, ..., Maske 27. Nach jedem Druckvorgang ist ein Maskenwechsel erforderlich. Wie Fig. 5 zu entnehmen ist, haben die Masken 25 bis 27 jeweils nebeneinanderliegend dreimal die gleiche Form. Maske 25 weist zwei rechteckige mittig geteilte Elektrodenabschnitte 23 mit jeweils einem in der Fig. 5 seitlichen Anschlußabschnitt, der der Einfachheit halber mit dem Bezugszeichen des entsprechenden Kopfkontaktes versehen ist, an den er letztlich angeschlossen wird. Maske 26 weist einen einteiligen Abschnitt für die Elektrode 22 mit einem in der Fig. 5 nach unten weisenden mittleren Abschnitt auf, der zum Anschluß an den Kopfkontakt 30 dient. Maske 27 weist wiederum getrennte Abschnitte für Elektroden 23 auf, die jeweils in der Fig. 5 unten links und rechts einen Abschnitt aufweisen zum Anschluß an die Kopfkontakte 33 und 34. Wie aus der Fig. 5 ersichtlich ist, wiederholt sich die Maskenstruktur dreifach in jeder horizontalen Reihe. Selbstverständlich kann auch eine Wiederholung der Maskenstrukturen gleicher Gestalt in senkrechter Richtung erfolgen. Es ist dabei durchaus möglich, die Maskenstruktur z.B. durch Drehen oder Spiegeln leicht abzuwandeln. In einem späteren Verfahrensschritt erfolgt dann eine Trennung der erzeugten und nebeneinanderliegenden Torsionsaktuatoren 10 beispielsweise durch Sägen entlang der dicken strichpunktierten Trennlinien 28. Die Trennlinien 28 ragen nicht direkt an die Elektrodenflächen 22 bzw. 23 heran, weil erfindungsgemäß nur die Verbindungen zu den äußeren Kopfkontakten 30 bis 34 entsprechend den Erfordernissen gemäß Fig. 4 freigelegt werden.

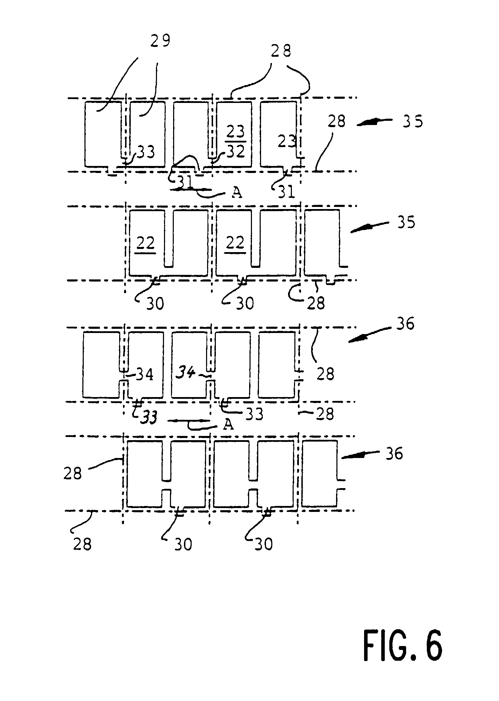

Um den Herstellungsaufwand für die drei unterschiedlichen Masken 25 bis 27 und deren ständiges Wechseln noch weiter zu reduzieren, wird in Fig. 6 eine zweite Maskenanordnung angegeben, bei der nur zwei unterschiedliche Masken 35 und 36 notwendig sind. Die ähnlich wie in Fig. 5 nebeneinander angeordneten Masken werden dabei in Pfeilrichtung A jeweils um eine halbe Breite des Aktuators entlang den horizontalen Trennlinien 28 verschoben. D.h. es sind nur zwei unterschiedlich ausgestaltete Masken vorhanden. Die Maske 35 weist dazu eine Grundfläche 29 auf, die zwei Elektrodenflächen je Hälfte des Aktuators aufweist, welche miteinander über einen Steg verbunden sind und gleichzeitig in der Fig. 6 nach unten weisend eine Elektrodenhälfte mit einer Anschlußfläche hat. Durch Verschieben der Trennlinien in Pfeilrichtung A kann somit eine Elektrode 22 bzw. 23 erzeugt werden. Dies ist in der oberen Hälfte von Fig. 6 dargestellt. Die Gestaltung der anderen Elektrode 36 ist sehr ähnlich der Maske 35, wobei wiederum ein Steg, der gegenüber Maske 35 versetzt ist, zwei Hälften von Elektrodenflächen verbindet, und gegenüber der Maske 35 versetzt ein Anschlußabschnitt an derjenigen Elektrodenhälfte und in der Fig. 6 nach unten weisend vorgesehen ist, die bei der Maske 35 keinen unteren Anschlußabschnitt aufweist. Wie auch in Fig. 5, sind die Anschlußabschnitte entsprechend den Kopfkontakten 30 bis 34 gekennzeichnet.

Die Verschiebung ist nach jedem Druck vorzunehmen und beträgt dabei, wie bereits erwähnt, eine halbe Breite des Torsionsaktuators 10 in Pfeilrichtung A. Nach dem Drucken werden die hergestellten Aktuatoren entlang der Trennlinien 28 getrennt, wobei wie bei den Masken gemäß Fig. 5 automatisch die entsprechenden Anschlußflächen herausragen, so daß die Kopfkontakte 30 bis 34 direkt erzeugt werden können. Nachteilig bei dieser zweiten Maskenanordnung ist die Tatsache, daß in der Fig. 6 links oder rechts jeweils ein Bereich von der Breite der Verschiebung nicht genutzt werden kann. Wie bereits erwähnt, entstehen die äußeren Verbindungen wie in Fig. 5, allerdings ist der Anschlußbereich 30 zweimal vorhanden und erfordert zwei Kopfkontakte 30, die zu verbinden sind. Die Reihenfolge der Masken kann wie folgt gewählt werden: Maske 35 unverschoben, Maske 35 verschoben, Maske 35 unverschoben, Maske 35 verschoben, ..., Maske 35 unverschoben, Maske 35 verschoben, Maske 36 unverschoben, Maske 36 verschoben, ..., Maske 36 verschoben. Daraus ist ersichtlich, daß ein Maskenwechsel von Maske 35 zu 36 genau einmal und zwar in der Mitte des Aktuators erfolgen muß.

In der vorstehenden Beschreibung, in den Fig. 1 bis 7 sowie in den Ansprüchen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Torsionsaktuaktor aus monolithischer piezoelektrischer Keramik, die vielschichtig übereinander angeordnet ist, mit Elektroden mindestens zwischen den Schichten und von außen zugänglichen Kopfkontakten zur Kontaktierung der Elektroden mit elektrischen Steuerspannungen mindestens zum Verwinden des Aktuators um seine Längsachse herum, wobei die Elektroden parallel zueinander und parallel zu den zueinander parallelen piezoelektrischen Schichten angeordnet sind, dadurch gekennzeichnet, daß die Elektroden (22, 23, 24) in Abstand zu den Rändern der piezoelektrischen Schichten (20) enden und bis an die Ränder der piezoelektrischen Schichten (20) ragende Anschlußflächen aufweisen, daß eine mittlere Elektrode (22) und davon ausgehend jede übernächste Elektrode (22) als Referenzelektroden (22) mit einer Referenzspannung verbunden sind, daß die zwischen den Referenzelektroden (22) angeordneten inneren Elektroden (23) halbseitig bezüglich der Mittellinie (39) der Stirnfläche (18) getrennt, quadrantenweise bezüglich der Mittellinien (19, 39) der Stirnfläche (18) mit seitlich angeordneten Kopfkontakten (30 bis 34) versehen sind und im ersten und vierten oder zweiten und dritten Quadrant auf positivem Potential und die übrigen auf negativem Potential bezüglich der Referenzspannung liegen, wobei die angrenzenden Schichten (20) zur Elektrode (22) orthogonal und gleichgerichtet polarisiert sind.

2. Torsionsaktuator nach Anspruch 1, dadurch gekennzeichnet, daß die ihn begrenzende obere und untere Fläche (37, 38) jeweils eine weitere Elektrode (24) aufweisen, die, wie die mittlere und zu den Flächen (37, 38) weisend jede übernächste Elektrode (22) über den Kopfkontakt (30) miteinander verbunden und mit einer als Referenzspannung dienenden Steuerspannung $U_0$ beaufschlagt sind.

3. Torsionsaktuator nach Anspruch 2, dadurch gekennzeichnet, daß die Elektroden (22, 24), die mit dem Kopfkontakt (30) verbunden sind, über die Längsachse (16) hinaus elektrisch verbunden sind.

4. Torsionsaktuator nach Anspruch 3, dadurch gekennzeichnet, daß die äußeren Elektroden (24) ganzflächig die piezoelektrischen Schichten (20) bedecken und Anschlußflächen bildende Ausspannungen an ihren Rändern aufweisen, um zusammen mit den inneren Elektroden (22) über Kopfkontakt (30) kontaktiert zu werden.

5. Torsionsaktuator nach Anspruch 4, dadurch gekennzeichnet, daß jeweils ein weiterer Kopfkontakt (31 bis 34) je Quadrant die verbleibenden Elektroden (23) verbindet und mit Spannungen $U_1$, $U_2$, $U_3$, $U_4$ beaufschlagt.

6. Torsionsaktuator nach einem oder mehreren der vorhergehenden Ansprüche, dadurch gekennzeichnet, daß das Verhältnis der Länge (11) zur halben Breite (13) des im wesentlichen plattenförmigen Aktuators (10) zwischen 1 und 3 liegt.

7. Torsionsaktuator nach einem oder mehreren der vorhergehenden Ansprüche, dadurch gekennzeichnet, daß bei vorgegebener Länge (11) sich ein maximaler Torsionswinkel (17) bei einem Verhältnis der Länge (11) zur halben Breite (13) von ca. 0,9 ergibt.

8. Torsionsaktuator nach Anspruch 7, dadurch gekennzeichnet, daß er eine rechteckige Grundfläche mit der Länge (11) und der Breite (13) aufweist, oder eine trapezförmige Grundfläche mit einer fest eingespannten Breite (13) und einer gegenüberliegenden breiteren beweglichen Seitenfläche (13').

9. Torsionsaktuator nach Anspruch 8, dadurch gekennzeichnet, daß bei einer trapezförmigen Grundfläche, bei der die breitere Breite (13') doppelt so breit wie die schmalere Breite (13) ist, eine Steigerung des Torsionswinkels (17) von ca. 33 % gegenüber einer rechteckförmigen Grundfläche eintritt.

10. Torsionsaktuator nach Anspruch 9, dadurch gekennzeichnet, daß die Torsions- bzw. Längsachse (16) bei Spannungen $U_1 = U_2$ und $U_3 = U_4$ durch Biegung zusätzlich beeinflußbar ist.

11. Verfahren zur Herstellung des Torsionsaktuators nach Anspruch 1 aus monolithischer piezoelektrischer Keramik, die vielschichtig übereinander angeordnet ist, mit Elektroden mindestens zwischen den Schichten und von außen zugänglichen Kopfkontakten zur Kontaktierung der Elektroden mit elektrischen Steuerspannungen zum Verwinden des Aktuators um seine Längsachse herum, dadurch gekennzeichnet, daß mehrere Siebdruckmasken (25, 26, 27; 35, 36) für die unterschiedlichen Elektroden (22, 23, 24) neben und/oder übereinander angeordnet nacheinander beim Aufbau der mehreren Schichten (20) von gleichzeitig mehreren Aktuatoren (10) eingesetzt werden, und durch eine Trennung entlang bestimmter Trennlinien (28) die erzeugten Aktuatoren (10) direkt die Anschlußflächen für die anzubringenden Kopfkontakte (30 bis 34) auf ihren Schnittflächen aufweisen.

12. Verfahren zur Herstellung des Torsionsaktuators nach Anspruch 11, dadurch gekennzeichnet, daß eine erste Maskenanordnung aus drei verschiedenen Masken (25, 26, 27) aufgebaut ist und jeweils mehrere davon aufweist, und für jeden Druckvorgang nacheinander die Maske (25), Maske (26), Maske (25), Maske (26), Maske (25), ... Maske (25), ... Maske (26), Maske (27), Maske (26), ... Maske (27) zum Einsatz kommt, wobei Maske (25) durch die Längsachse (16) getrennte Elektroden und seitliche Anschlußflächen (31, 32) und Maske (26) eine einzige durchgehende Elektrode und eine mittlere vordere Anschlußfläche (30) und Maske (27) durch die Längsachse (16) getrennte Elektroden und je Elektrode eine vordere Anschlußfläche (33, 34) nach dem Trennen entlang der Trennlinie (28) auf den Trennflächen aufweisen.

13. Verfahren zur Herstellung eines Torsionsaktuators nach Anspruch 11, dadurch gekennzeichnet, daß eine zweite Maskenanordnung aus zwei verschiedenen Masken (35, 36) aufgebaut ist, und jeweils mehrere davon nebeneinander aufweist, die je Druckvorgang um eine halbe Breite (13) des Aktuators verschoben werden, wodurch nach dem Trennen entlang der Trennlinien (28) die Elektroden (22, 23, 24) erzeugt werden.

14. Verfahren zur Herstellung eines Torsionsaktuators nach Anspruch 13, dadurch gekennzeichnet, daß genau ein Maskenwechsel von Maske (35) auf Maske (36) durchgeführt wird, bei folgender Druckfolge: Maske (35) unverschoben, Maske (35) verschoben, Maske (35) unverschoben, Maske (35) verschoben, ... Maske (35) unverschoben, Maske (35) verschoben, Maske (36) unverschoben, Maske (36) verschoben, ... Maske (36) verschoben.

15. Verfahren zur Herstellung eines Torsionsaktuators nach Anspruch 14, dadurch gekennzeichnet, daß die Maske (35) eine Grundfläche mit zwei Elektrodenflächen je Hälfte des Aktuators (10) aufweist, die miteinander über einen Steg verbunden sind und in Längsrichtung des Aktuators (10) weisend eine Elektrodenhälfte mit einer Anschlußfläche hat.

16. Verfahren zur Herstellung eines Torsionsaktuators nach Anspruch 15,
dadurch gekennzeichnet, daß die Maske (36) eine Grundfläche (29) mit zwei Elektrodenflächen je Hälfte des Aktuators (10) aufweist, die miteinander über einen gegenüber Maske (35) versetzten Steg verbunden sind und in Längsrichtung des Aktuators (10) weisend, die gegenüber Maske (35) andere Elektrodenhälfte versetzt eine Anschlußfläche hat.

**Claims**

1. A torsional actuator of monolithic piezo-electric ceramic which is arranged so as to form a multilayer structure, comprising electrodes which are situated at least between the layers, and comprising head contacts which are accessible from the outside and which serve to supply control voltages to the electrodes, to cause the actuator to at least be twisted about its longitudinal axis, the electrodes extending parallel to each other and parallel to the parallel piezo-electric layers, characterized in that the electrodes (22, 23, 24) end at a distance from the edges of the piezo-electric layers (20), and comprise connecting surfaces which extend as far as the edges of the piezo-electric layers (20), in that a reference voltage is applied to a central electrode (22) and, subsequently, to every alternate electrode (22) which serve as reference electrodes (22), in that the inner electrodes (23) arranged between the reference electrodes (22) are divided into two parts with respect to the center line (39) of the end face (18) and are provided with lateral head contacts (30 to 34) at the location of the quadrants formed by the center lines (19, 39) of the end face (18), the inner electrodes in the first and fourth or in the second and third quadrant being at a positive potential, while the other inner electrodes are at a negative potential with respect to the reference voltage, with the adjoining layers (20) being orthogonally and unidirectionally polarized with respect to the electrode (22).

2. A torsional actuator as claimed in Claim 1, characterized in that both the upper and lower surfaces (37, 38) bounding the torsional actuator each comprise a further electrode (24), which electrodes like the central electrode and alternate electrodes (22) which are directed towards the surfaces (37, 38), are interconnected via the head contact (30) and to which electrodes a control voltage $U_o$ is applied which serves as the reference voltage.

3. A torsional actuator as claimed in Claim 2, characterized in that the electrodes (22, 24) which are connected to the head contact (30), are electrically interconnected in the direction of the longitudinal axis (16).

4. A torsional actuator as claimed in Claim 3, characterized in that the outer electrodes (24) entirely cover the piezo-electric layers (20) and comprise projecting edge portions forming connective surfaces, so that they can be contacted along with the inner electrodes (22) via the head contact (30).

5. A torsional actuator as claimed in Claim 4, characterized in that a further head contact (31 to 34) for each quadrant interconnects the remaining electrodes (23) and applies voltages $U_1$, $U_2$, $U_3$, $U_4$, to said electrodes.

6. A torsional actuator as claimed in any one of the preceding Claims, characterized in that the ratio of the length (11) to half the width (13) of the basically plate-shaped actuator (10) ranges between 1 and 3.

7. A torsional actuator as claimed in any one of the preceding Claims, characterized in that at a predetermined length (11), a maximum angle of torsion (17) is obtained at a ratio of the length (11) to half the width (13) of approximately 0.9.

8. A torsional actuator as claimed in Claim 7, characterized in that it comprises a rectangular base having a length (11) and a width (13), or a trapezoidal base having a rigidly fixed side face of width (13) and a movable opposite side face (13') of a greater width.

9. A torsional actuator as claimed in Claim 8, characterized in that in the case of a trapezoidal base, in which the larger width (13') is twice the smaller width (13), an increase of the angle of torsion (17) of approximately 33% is obtained as compared to a rectangular base.

10. A torsional actuator as claimed in Claim 9, characterized in that the torsional or longitudinal axis (16) can be additionally influenced at voltages $U_1$, $= U_2$ and $U_3 = U_4$ by bending.

11. A method of manufacturing the torsional actuator as claimed in Claim 1, wherein monolithic piezo-electric ceramic is arranged so as to form a multilayer structure comprising electrodes situated at least between the layers and further comprising head contacts which are accessible from the outside and which serve to apply control voltages to the electrodes to cause the electrode to be twisted about its longitudinal axis, characterized in that a plurality of screen-printing masks (25, 26, 27; 35, 36) for the different electrodes (22, 23, 24) are arranged next to each other or above each other and are successively used for simultaneously building up a plurality of layers (20) in a plurality of actuators (10), and that, as a result of division along specific parting lines (28), the actuators (10) thus produced immediately exhibit, at the cut surfaces, the connecting surfaces for the head contacts (30 to 34) to be provided.

12. A method of manufacturing the torsional actuator as claimed in Claim 11, characterized in that a first mask arrangement is built up of three different masks (25, 26, 27) and comprises a plurality of each of said masks, and in each printing process, in succession, mask (25), mask (26), mask (25), mask (26), mask (25) .... mask (25), ... mask (26), mask (27), mask (26) ,... mask (27) is used, mask (25) comprising electrodes, which are divided by the longitudinal axis (16) and lateral connecting surfaces (31, 32), mask (26) comprising a single undivided electrode and a centrally positioned, front connecting surface (30) and mask (27) comprising electrodes which are divided by the longitudinal axis (16) and, after the division along the parting line (28), a front connecting surface (33, 34) on the parting faces for each electrode.

13. A method of manufacturing a torsional actuator as claimed in Claim 11, characterized in that a second mask arrangement is built up of two different masks (35, 36), said mask arrangement comprising a plurality of said masks arranged in a side by side relationship, in each printing process each mask being displaced over a half width (13) of the actuator, as a result of which the electrodes (22, 23, 24) are produced after the division along the parting lines (28).

14. A method of manufacturing a torsional actuator as claimed in Claim 13, characterized in that one mask-exchange operation is carried out in which mask (35) is exchanged for mask (36), the printing sequence being the following: mask (35) not displaced, mask (35) displaced, mask (35) not displaced, mask (35) displaced, ... mask (35) not displaced, mask (35) displaced, mask (36) not displaced, mask (36) displaced, ... mask (36) displaced.

15. A method of manufacturing a torsional actuator as claimed in Claim 14, characterized in that the mask (35) comprises a base having two electrode surfaces for each half actuator (10), said electrode surfaces being interconnected via a connecting element and said mask having, in the longitudinal direction of the actuator (10), an electrode half having a connecting surface.

16. A method of manufacturing a torsional actuator as claimed in Claim 15, characterized in that the mask (36) comprises a base (29) having two electrode surfaces for each half of the actuator (10), which electrode surfaces are interconnected via a connecting element which is offset with respect to the mask (35), and in that, in the longitudinal direction of the actuator (10), the other electrode half with respect to mask (35) has a displaced connecting surface.

## Revendications

1. Actionneur à torsion en céramique piézo-électrique monolithique composé de couches multiples superposées avec des électrodes, au moins entre les couches et de pastilles accessibles de l'extérieur pour le contact des électrodes avec des tensions de commande électriques au moins pour la torsion de l'actionneur autour de son axe longitudinal, les électrodes étant disposées parallèlement l'une à l'autre et parallèlement aux couches piézo-électriques parallèles l'une à l'autre, caractérisé en ce que les électrodes (22, 23, 24) se terminent à un intervalle des bords des couches piézo-électriques (20) et présentent des surfaces de connexion s'étendant jusqu'aux bords des couches piézo-électriques (20), qu'une électrode centrale (22) et, à partir de là, chaque électrode suivante (22) sont reliées comme des électrodes de référence (22) à une tension de référence, que les électrodes internes (23) disposées entre les électrodes de référence (22) sont séparées en moitiés par rapport à la ligne médiane (39) de la face d'about (18), sont dotées de pastilles (30 à 34) disposées latéralement en quadrants par rapport aux lignes médianes (19, 39) de la face d'about (18) et se trouvent sur le potentiel positif dans les premier et quatrième ou deuxième et troisième quadrants et sur le potentiel négatif dans les autres pour la tension de référence, les couches adjacentes (20) à l'électrode (22) étant polarisées de manière orthogonale et redressée.

2. Actionneur à torsion selon la revendication 1, caractérisé en ce que les surfaces supérieure et inférieure (37, 38) qui le délimitent présentent respectivement des électrodes (24) supplémentaires qui, comme l'électrode centrale et chaque électrode suivante (22) vers les surfaces (37, 38), sont reliées entre elles par l'intermédiaire de la pastille (30) et sont alimentées en une tension de commande $U_0$ servant de tension de référence.

3. Actionneur à torsion selon la revendication 2, caractérisé en ce que les électrodes (22, 24) qui sont reliées à la pastille (30) sont reliées électriquement au-delà de l'axe longitudinal (16).

4. Actionneur à torsion selon la revendication 3, caractérisé en ce que les électrodes externes (24) recouvrent les couches piézo-électriques (20) sur toute leur surface et présentent sur leurs bords des saillies formant des surfaces de connexion pour entrer en contact avec les électrodes internes (22) par l'intermédiaire d'une pastille (30).

5. Actionneur de torsion selon la revendication 4, caractérisé en ce qu'une autre pastille (31 à 34) relie pour chaque quadrant les électrodes résiduelles (23) et les alimente en tensions $U_1$, $U_2$, $U_3$, $U_4$.

6. Actionneur à torsion selon l'une ou plusieurs des revendications précédentes, caractérisé en ce que le rapport de la longueur (11) à la demi-largeur (13) de l'actionneur (10) essentiellement en forme de plaque se situe entre 1 et 3.

7. Actionneur à torsion selon l'une ou plusieurs des revendications précédentes, caractérisé en ce que, pour une longueur (11) déterminée, un angle de torsion maximal (17) est obtenu pour un rapport de la longueur (11) à la demi-largeur (13) d'environ 0,9.

8. Actionneur à torsion selon la revendication 7, caractérisé en ce qu'il présente une base rectangulaire ayant la longueur (11) et la largeur (13) ou une base trapézoïdale avec une largeur (13) encastrée et une surface latérale (13') mobile plus large opposée.

9. Actionneur à torsion selon la revendication 8, caractérisé en ce que, pour une base trapézoïdale dans laquelle la plus grande largeur (13') est deux fois plus grande que la plus petite largeur (13), il se produit une augmentation de l'angle de torsion (17) d'environ 33 % par rapport à une base rectangulaire.

10. Actionneur à torsion selon la revendication 9, caractérisé en ce que l'axe de torsion ou l'axe longitudinal (16) peut en plus être influencé par flexion pour des tensions $U_1 = U_2$ et $U_3 = U_4$.

11. Procédé de fabrication de l'actionneur à torsion selon la revendication 1 à partir de céramique piézo-électrique monolithique qui est composé de plusieurs couches superposées, avec des électrodes au moins entre les couches et des pastilles accessibles de l'extérieur pour le contact des électrodes avec des tensions de commande électriques en vue de la rotation de l'actionneur autour de son axe longitudinal, caractérisé en ce que plusieurs masques de sérigraphie (25, 26, 27; 35, 36) placés côte à côte ou superposés sont utilisés successivement pour les différentes électrodes (22, 23, 24) pour la formation des plusieurs couches (20) de plusieurs actionneurs (10) en même temps et les actionneurs (10) produits présentent directement les surfaces de connexion pour les pastilles à appliquer (30 à 34) sur leurs surfaces de découpe par une séparation le long de lignes de séparation (28) déterminées.

12. Procédé de fabrication de l'actionneur à torsion selon la revendication 11, caractérisé en ce qu'un premier agencement des masques est composé de trois masques différents (25, 26, 27) et en présente respectivement plusieurs d'entre eux et, pour chaque opération de sérigraphie, le masque (25), le masque (26), le masque (25), le masque (26), le masque (25), ... le masque (25), ... le masque (26), le masque (27), le masque (26), ... le masque (27) sont successivement utilisés, le masque (25) présentant des électrodes séparées par l'axe longitudinal (16) et des surfaces de connexion latérales (31, 32) et le masque (26) une seule électrode continue et une surface de connexion (30) antérieure centrale et le masque (27) présentant des électrodes séparées par l'axe longitudinal (16) et, par électrode, une surface de connexion antérieure (33, 34) après la séparation le long de la ligne de séparation (28) sur les surfaces de séparation.

13. Procédé de fabrication d'un actionneur à torsion selon la revendication 11, caractérisé en ce qu'un deuxième agencement de masques est composé de deux masques différents (35, 36) et en présente respectivement plusieurs côte à côte qui, à chaque opération de sérigraphie, sont décalés d'une demi-largeur (13) de l'actionneur, si bien qu'après la séparation le long des lignes de séparation (28), les électrodes (22, 23, 24) sont produites.

14. Procédé de fabrication d'un actionneur à torsion selon la revendication 13, caractérisé en ce qu'un remplacement du masque (35) par le masque (36) est effectué dans l'ordre de sérigraphie suivant: masque (35) non décalé, masque (35) décalé, masque (35) non décalé, masque (35) décalé ... masque (35) non décalé, masque (35) décalé, masque (36) non décalé, masque (36) décalé, ... masque (36) décalé.

15. Procédé de fabrication d'un actionneur à torsion selon la revendication 14, caractérisé en ce que le masque (35) présente une base avec deux surfaces d'électrodes pour chaque moitié de l'actionneur (10) qui sont reliées entre elles par l'intermédiaire d'une nervure et a une moitié d'électrode avec une surface de connexion, vue dans la direction longitudinale de l'actionneur (10).

16. Procédé de fabrication d'un actionneur à torsion selon la revendication 15, caractérisé en ce que le masque (36) présente une base (29) avec deux surfaces d'électrode par moitié de l'actionneur (10) qui sont reliées entre elles par l'intermédiaire d'une nervure décalée par rapport au masque (35) et, vue en direction longitudinale de l'actionneur (10), l'autre moitié d'électrode par rapport au masque (35) a une surface de connexion décalée.

FIG. 1

EP 0 646 975 B1

FIG. 2

FIG. 3

FIG. 4

FIG. 5

FIG. 7

FIG. 6